# EUROPÄISCHE PATENTSCHRIFT

(11) **EP 0 908 016 B1**
(45) Veröffentlichungstag und Bekanntmachung des Hinweises auf die Patenterteilung: **11.09.2002**
(21) Anmeldenummer: 97931657.7
(22) Anmeldetag: 25.06.1997
(51) Int. Cl.: H03M 1/74, G06J 1/00

(54) **SCHALTUNGSANORDNUNG ZUR DIGITALEN EINSTELLUNG ANALOGER PARAMETER**
CIRCUIT FOR THE DIGITAL SETTING OF ANALOGUE PARAMETERS
CIRCUIT POUR LE REGLAGE NUMERIQUE DE PARAMETRES ANALOGIQUES

(30) Priorität: 26.06.1996 DE 19625624
(43) Veröffentlichungstag der Anmeldung: 14.04.1999
(73) Patentinhaber: Infineon Technologies AG, 81669 München (DE)
(72) Erfinder: WEBER, Stephan, D-81739 München (DE)
(74) Vertreter: Fischer, Volker, Dipl.-Ing.
(86) Internationale Anmeldenummer: DE9701325
(87) Internationale Veröffentlichungsnummer: WO97050178

(56) Entgegenhaltungen:
- US-A- 3 309 508
- US-A- 3 651 517
- US-A- 4 931 674
- U. TIETZE ET AL.: "Halbleiter-Schaltungstechnik" 1989 , SPRINGER VERLAG , BERLIN, DE XP002045527 016011 in der Anmeldung erwähnt Seiten 443-450 (Kapitel 14.11) und 752-759 (Kapitel 23.2, 23.3) siehe Seite 449, Absatz 1; Abbildung 23.9

## Beschreibung

Die Erfindung betrifft eine Schaltungsanordnung zur digitalen Einstellung analoger Parameter.

Derartige Schaltungsanordnungen werden beispielsweise zur digitalen Einstellung der Filterparameter eines analogen Filters oder zur digitalen Einstellung der Verstärkung eines analogen Verstärkers verwendet.

Aus U. Tietze, Ch. Schenk, Electronic Circuits-Design and Applications, Berlin, Heidelberg 1991, Seiten 399 bis 402 ist bekannt, für die digitale Einstellung der jeweiligen Parameter einen Digital-Analog-Umsetzer mit Widerstandsnetzwerk zu verwenden, der an die Stelle des entsprechenden, den jeweiligen Parameter realisierenden Widerstandselementes tritt.

In US 3,309,508 ist eine Schaltungsanordnung zur Multiplikation zweier analoger Spannungen beschrieben, bei der die erste der beiden Spannungen vor der Multiplikation in eine digitale Darstellung gewandelt wird. Jedes einzelne Bit der digitalen Darstellung schaltet einen Stromschalter, dessen Eingang mit der zweiten analogen Spannung beschaltet ist. Der aus den Stromschaltern fließende Strom wird dann über Widerstände gewichtet, wobei der Widerstandswert jeweils der Gewichtung des jeweiligen Bits entspricht und für eine präzises Ergebnis genau eingestellt werden muß.

In integrierte Schaltkreise mitintegrierte Widerstände haben jedoch eine große Bauteiletoleranz sowie einen beträchtlichen Temperaturgang, so daß man mit ihnen nur sehr unkritische Anordnungen realisieren kann oder aber erheblichen zusätzlichen Aufwand benötigt, um eine ausreichende Genauigkeit und Konstanz zu erreichen. Digital einstellbare Filter höherer Ordnung mit höherer Genauigkeit erfordern daher einen verhältnismäßig großen Schaltungsaufwand.

Aufgabe der Erfindung ist es, eine Schaltungsanordnung zur digitalen Einstellung analoger Parameter anzugeben, die einen geringeren schaltungstechnischen Aufwand erfordert.

Die Aufgabe wird gelöst durch eine Schaltungsanordnung gemäß Patentanspruch 1. Ausgestaltungen und Weiterbildungen des Erfindungsgedankens sind Gegenstand von Unteransprüchen.

Im einzelnen werden mindestens zwei analoge Multipliziereinrichtungen vorgesehen, deren eine Eingänge einander parallel geschaltet sind sowie durch ein Eingangssignal angesteuert werden, auf deren andere Eingänge jeweils ein Gewichtungssignal in Abhängigkeit von einem entsprechenden Steuersignal aufschaltbar ist und deren Ausgänge additiv miteinander gekoppelt sind.

Dabei können die Multipliziereinrichtungen Stromausgange aufweisen, die einander parallel geschaltet sind.

Die Multipliziereinrichtungen können auch Differenzverstarkerstufen aufweisen, an deren Differenzeingängen das Eingangssignal angelegt ist und deren an-/abschaltbare Speiseströme den Gewichtungssignalen entsprechen.

Bevorzugt werden die Gewichtungssignale binär abgestuft, um eine Einstellung der analogen Parameter entsprechend mehrstelliger Binärworte vornehmen zu können.

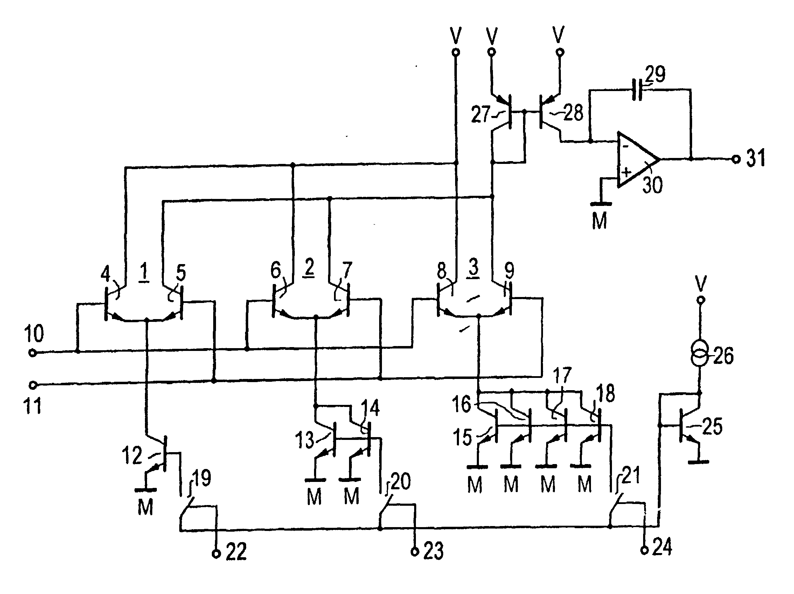

Die Erfindung wird nachfolgend anhand des in der einzigen Figur der Zeichnung dargestellten Ausführungsbeispiels näher erläutert.

Bei der als Ausführungsbeispiel gezeigten Ausführungsform sind drei Multipliziereinrichtungen 1, 2, 3 vorgesehen, die jeweils zwei emittergekoppelte npn-Transistoren 4, 5 bzw. 6, 7 bzw. 8, 9 aufweisen. Die Multipliziereinrichtungen 1, 2, 3 sind eingangsseitig einander parallel geschaltet, so daß die Basen der Transistoren 4, 6, 8 bzw. die Basen der Transistoren 5, 7, 9 zusammen jeweils einen Differenzeingang bildend verschaltet sind, wobei an diese Eingänge ein differentielles Eingangssignal 10, 11 angelegt ist.

Die gekoppelten Emitter der Transistoren 4, 5 bzw. 6, 7 bzw. 8, 9 bilden dabei weitere Eingänge der Multipliziereinrichtungen 1, 2, 3, an die Gewichtungssignale angelegt werden. An den Kollektoren der Transistoren 4, 5 bzw. 6, 7 bzw. 8, 9 stehen dabei jeweils Ausgangsströme bereit, die gleich dem Produkt sind aus einer das Eingangssignal 10, 11 bildenden Eingangsspannung sowie einem das jeweilige Gewichtungssignal bildenden, in die gekoppelten Emitter der Transistoren 4, 5 bzw. 6, 7 bzw. 8, 9 eingespeisten Strom. Diese Ströme werden durch die Ausgangszweige einer Strombank gebildet, wobei die einzelnen Ausgangszweige unterschiedliche Stromdichten aufweisen und jeweils einzeln auf den Eingangszweig aufschaltbar sind. Zur Erzeugung unterschiedlicher Stromdichten wird jeweils eine unterschiedliche Anzahl gleicher Transistoren pro Ausgangszweig parallel geschaltet. So wird der der Multipliziereinrichtung 1 zuordenbare Ausgangszweig durch einen Transistor 12, der der Multipliziereinrichtung 2 zuordenbare Ausgangszweig durch zwei npn-Transistoren 13 und 14 sowie der der Multipliziereinrichtung 3 zuordenbare Ausgangszweig durch vier npn-Transistoren 15 bis 18 gebildet. Die Emitter der Transistoren 12 bis 18 sind dabei mit einem Bezugspotential M verbunden, während ihre Kollektoren entsprechend der jeweiligen Zuordnung mit den gekoppelten Emittern der Transistoren 4, 5 bzw. 6, 7 bzw. 8, 9 verschaltet sind. Die Basen der Transistoren 12 bis 18 sind entsprechend ihrer Zuordnung gruppenweise miteinander verschaltet und über jeweils einen gesteuerten Schalter 19, 20, 21 auf den zugehörigen Eingangszweig auf schaltbar. Die Schalter 19 bis 21 werden durch entsprechende Steuersignale 22 bis 24 gesteuert. Die Steuersignale 22 bis 24 sind entsprechend der binären Abstufung der einzelnen Ausgangszweige des Stromspiegels binär kodiert.

Der Eingangszweig des Stromspiegels wird durch einen npn-Transistor 25 gebildet, dessen Emitter mit dem Bezugspotential M verbunden ist und dessen Basis und Kollektor miteinander verschaltet und über eine gemeinsame Stromquelle 26 mit einem Versorgungspotential V verbunden sind. Über der Emitter-Kollektor-Strecke des Transistors 25 liegt damit eine Spannung an, die über die Schalter 22 bis 24 auf die Basis-Emitter-Strecken der Transistoren 12 bis 18 aufschaltbar ist.

Zur additiven Kopplung der Ausgänge der Multipliziereinrichtungen 1, 2, 3 sind zum einen die Kollektoren der Transistoren 4, 6, 8 miteinander und zum anderen die Kollektoren der Transistoren 5, 7, 9 miteinander verschaltet. Die Kollektorer der Transistoren 4, 6, 8 sind dabei direkt mit dem Versorgungspotential V verbunden, während die Kollektoren der Transistoren 5, 7, 9 unter Zwischenschaltung des Eingangskreises eines weiteren Stromspiegels mit dem Versorgungspotential V gekoppelt sind. Der Eingangskreis des weiteren Stromspiegels wird durch einen pnp-Transistor 27 gebildet, dessen Emitter an das Versorgungspotential V angeschlossen ist und dessen Basis und Kollektor sowohl mit den Kollektoren der Transistoren 5, 7 und 9 als auch mit der Basis eines pnp-Transistors 28 verbunden ist. Der Kollektor des Transistors 28, dessen Emitter ebenfalls an das Versorgungspotential V angeschlossen ist, bildet den Ausgang der erfindungsgemäßen Schaltungsanordnung.

Beim Ausführungsbeispiel wird die erfindungsgemäße Schaltungsanordnung im Rahmen eines analogen Integrators eingesetzt, dessen Integrationszeitkonstante bei einer gegebenen, konstanten Kapazität 29 mittels der binären Signale 22 bis 24 digital einstellbar ist. Zu diesem Zweck ist der Kollektor des Transistors 28 mit dem invertierenden Eingang eines Operationsverstärkers 30 gekoppelt, dessen nichtinvertierender Eingang an das Bezugspotential M angeschlossen ist. Zwischen Ausgang und invertierendem Eingang des Operationsverstärkers 30 ist dabei die Kapazität 29 geschaltet. Am Ausgang des Operationsverstärkers 30 ist ein Ausgangssignal 31 abnehmbar, daß aus dem Eingangssignal 10, 11 durch Integration mit einer mittels der Steuersignale 22 bis 24 einstellbaren Zeitkonstante hervorgeht. Ein derartiger Integrator ist seinerseits beispielsweise wiederum im Rahmen eines Universalfilters anwendbar.

Wie zu ersehen ist, werden zur Parametereinstellung bei einer erfindungsgemäßen Schaltungsanordnung keine Widerstandselemente, sondern in integrierter Schaltungstechnik wesentlich einfacher herstellbare Transistorelemente verwendet, so daß sich insgesamt bei erheblich geringerem Schaltungsaufwand eine höhere Genauigkeit und Konstanz ergibt.

## Patentansprüche

1. Schaltungsanordnung zur digitalen Einstellung analoger Parameter mit mindestens zwei analogen Multipliziereinrichtungen (1, 2, 3), die jeweils eine Differenzverstärkerstufe (4 bis 9) mit differentiellen Eingängen aufweisen, wobei die Ausgänge der Differenzverstärkerstufen additiv miteinander gekoppelt sind, die Speiseströme der Differenzverstärkerstufen an-/abschaltbar und binär abgestuft sind,
**dadurch gekennzeichnet, daß**
- die differentiellen Eingänge der Differenzverstärkerstufen (4 bis 9) einander parallel geschaltet sind und durch ein analoges bipolares Eingangssignal (10, 11) angesteuert werden,
- die Speiseströme der Differenzverstärkerstufen jeweils einzeln in Abhängigkeit von einem entsprechenden digitalen Steuersignal (22, 23, 24) an-/abschaltbar sind,
- die Differenzverstärkerstufen (4 bis 9) jeweils zwei emittergekoppelte Transistor umfassen, von denen die Basisanschlüsse von ersten Transistoren (4, 6, 8) und die Basisanschlüsse von zweiten Transistoren (5, 7, 9) jeweils miteinander verbunden sind zur Bildung eines Differenzeingangs zur Ansteuerung mit dem Eingangssignal (10, 11),
- die Emitterknoten der Differenzverstärkerstufen (4 bis 9) jeweils über binär abgestufte und einzeln an/abschaltbare Stromquellen (12 bis 18) mit einem Bezugspotentialanschluß (M) verbunden sind, und
- eine gemeinsame Stromquelle (26) vorgesehen ist, die zur Speisung der Differenzverstärkerstufen (4 bis 9) über je einen Stromspiegel (12, 25; 13, 14, 25; 15, 16, 17, 18, 25), aufweisend einen gemeinsamen Eingangszweig (25), mit je einer Differenzverstärkerstufe (4 bis 9) abschaltbar gekoppelt ist.

2. Schaltungsanordnung nach Anspruch 1,
**dadurch gekennzeichnet, daß**
die Stromspiegel je einen Schalter (22, 23, 24) zum An-/Abschalten der Speiseströme der Differenzverstärkerstufen (4 bis 9) umfassen, der zwischen den Eingangszweig der Stromspiegel (25) und je einen Ausgangszweig je eines Stromspiegels (12; 13, 14; 15 bis 18) geschaltet ist.

## Claims

1. Circuit arrangement for digitally setting analogue parameters having at least two analogue multiplying devices (1, 2, 3) which each have a differential amplifier stage (4 to 9) with differential inputs, in which arrangement the outputs of the differential amplifier stages are coupled to one another cumulatively and the supply currents of the differential amplifier stages can be switched on and off and are graded using binary code, **characterized in that**
- the differential inputs of the differential amplifier stages (4 to 9) are connected in parallel with one another and are driven by an analogue bipolar input signal (10, 11),
- the supply currents of the differential amplifier stages can each be switched on and off individually as a function of a corresponding digital control signal (22, 23, 24),
- the differential amplifier stages (4 to 9) respectively comprise two emitter-coupled transistors, of which the base connections of first transistors (4, 6, 8) and the base connections of second transistors (5, 7, 9) are respectively connected to one another to form a differential input for driving with the input signal (10, 11),
- the emitter nodes of the differential amplifier stages (4 to 9) are respectively connected to a reference-earth potential connection (M) via current sources (12 to 18) which are graded using binary code and can be switched on/off individually, and
- a common current source (26) is provided which, for the purpose of supplying the differential amplifier stages (4 to 9), is coupled, with the option of being switched off, to a respective differential amplifier stage (4 to 9) via a respective current mirror (12, 25; 13, 14, 25; 15, 16, 17, 18, 25) having a common input path (25).

2. Circuit arrangement according to Claim 1,
**characterized in that**
the current mirrors comprise a respective switch (22, 23, 24) for switching on/off the supply currents of the differential amplifier stages (4 to 9), said switch being connected between the input path of the current mirrors (25) and a respective output path of a respective current mirror (12; 13, 14; 15 to 18).

## Revendications

1. Circuit de réglage numérique de paramètres analogiques comprenant au moins deux dispositifs (1, 2, 3) multiplicateurs analogiques, qui ont respectivement un étage (4 à 9) amplificateur différentiel à entrées différentielles, les sorties des étages amplificateurs différentiels étant couplées entre elles de manière additive et les courants d'alimentation des étages amplificateurs différentiels pouvant être appliqués et interrompus et étant étagés de manière binaire,
**caractérisé en ce que**
- les entrées différentielles des étages (4 à 9) amplificateurs différentiels sont montées parallèlement les unes aux autres et sont commandées par un signal (10, 11) d'entrée analogique bipolaire,
- les courant d'alimentation des étages amplificateurs différentiels peuvent être appliqués/interrompus respectivement individuellement en fonction d'un signal (22, 23, 24) de commande numérique correspondant,
- les étages (4 à 9) amplificateurs différentiels comprennent respectivement deux transistors couplés à l'émetteur, dont les bornes de base de premiers transistors (4, 6, 8) et les bornes de base de deuxièmes transistors (5, 7, 9) sont reliées respectivement entre elles pour former une entrée différentielle pour la commande par le signal (10, 11) d'entrée,
- les noeuds d'émetteur des étages (4 à 9) amplificateurs différentiels sont reliés à une borne (M) de potentiel de référence respectivement par des sources (12 à 18) de courant étagées de manière binaire et pouvant être appliquées/interrompues individuellement, et
- il est prévu une source (26) commune de courant qui, pour l'alimentation des étages (4 à 9) amplificateurs différentiels est couplée avec possibilité d'interruption à respectivement l'un des étages (4 à 9) amplificateurs différentiels par respectivement une branche (25) commune d'entrée comportant un miroir de courant (12, 25 ; 13, 14, 25 ; 15, 16, 17, 18, 25).

2. Circuit selon la revendication 1, **caractérisé en ce que** les miroirs de courant comprennent respectivement un commutateur (22, 23, 24) pour appliquer/interrompre les courants d'alimentation des étages (4 à 9) amplificateurs différentiels, qui est monté entre la branche d'entrée du miroir de courant (25) et respectivement une branche de sortie de respectivement un miroir de courant (12 ; 13, 14 ; 15 à 18).
